# EUROPÄISCHE PATENTSCHRIFT

(11) **EP 0 414 142 B1**
(45) Veröffentlichungstag und Bekanntmachung des Hinweises auf die Patenterteilung: **27.03.1996**
(21) Anmeldenummer: 90115781.8
(22) Anmeldetag: 17.08.1990
(51) Int. Cl.: G01R 31/02, G01R 31/28, G08B 29/12

(54) **Überwachungs- und Steuersystem und Verfahren zur Erfassung zeitweise auftretender Fehler**
Monitoring and controlling system and method of acquisition of random errors
Système de surveillance et de contrôle et méthode d'enregistrement d'erreurs aléatoires

(30) Priorität: 24.08.1989 US 397820
(43) Veröffentlichungstag der Anmeldung: 27.02.1991
(73) Patentinhaber: DEERE & COMPANY, Moline, Illinois 61265 (US)
(72) Erfinder: Farber, Arnold Stanley, Cedar Falls, Iowa 50613 (US); Lang, Stephen Paul, Waterloo, Iowa 50702 (US); Smart, David Charles,, Waterloo, Iowa 50701, (US)
(74) Vertreter: Feldmann, Bernhard

(56) Entgegenhaltungen:
- EP-A- 0 072 000
- EP-A- 0 163 845
- EP-A- 0 398 593
- WO-A-84/04829
- WO-A-87/07388
- WO-A-88/02122
- DE-A- 3 121 645
- GB-A- 2 189 613
- US-A- 4 504 782
- Automatisierungstechnik at, 33. Jahrgang, Heft 1 (1985), Seiten 6 - 13; W. Jakoby."Diskrete adaptive Regler - Versuch einer Einordnung"

## Beschreibung

Die Erfindung betrifft ein Überwachungs- und/oder Steuersystem mit mehreren Vorrichtungen, die elektrisch über zugehörige Leitungen mit einer zentralen Einheit in Verbindung stehen, gemäß dem Oberbegriff des Anspruchs, 1 sowie Verfahren zur Erfassung und Diagnose zeitweise auftretender Fehler.

Elektrische Überwachungs- und/oder Steuersysteme sind bekannt. Derartige Systeme beinhalten in der Regel Sensoren oder Sendeeinrichtungen, welche über elektrische Leitungen oder Kabel mit einer Datenverarbeitungs- oder Steuereinheit verbunden sind. Zeitweise auftretende Fehler, wie Kurzschlüsse oder Kabelunterbrechungen lassen sich dabei nur schwer erkennen und zuordnen. Beispielsweise könnte der Fehler gerade dann nicht auftreten, wenn eine Bedienungsperson anwesend ist, oder der Fehler könnte gerade dann verschwinden, wenn die Bedienungsperson eine Fehlerdiagnose durchführt. Folglich ist es wünschenswert, ein Überwachungs- oder Steuersystem zu haben, welches die Fähigkeit zum erleichterten Wahrnehmen und Zuordnen eines derartigen, zeitweise auftretenden Fehlers enthält.

Durch die GB-A-2 189 613 ist ein elektrischer Testkreis zur Überprüfung von Alarmanlagen bekannt geworden. Der Testkreis besteht im wesentlichen aus einer zwischen zwei Anschlüssen in Reihe liegenen Spannungsquelle, einem Schalter und einem Meßwerk. Das Meßwerk gibt einen Meßwert aus, der dem Zustand zwischen den Anschlüssen entspricht. Ein in einem Speicher ablegbarer Referenzwert läßt sich durch Vorwahlmittel einstellen. Ein Komparator vergleicht den von dem Meßwerk ausgegebenen Meßwert mit dem Referenzwert. Weichen die Werte voneinander ab, so wird ein Warnsignal ausgegeben. Die Anschlüsse dieses Testkreises sind an einen Sensorkreis der Alarmanlage anschließbar, um diesen auf Fehler zu testen. Dabei wird zunächst ein bestimmter, einem fehlerfreien Zustand des Sensorkreises entsprechender Referenzwert ermittelt und eingestellt. Bei späteren Überprüfungen des Sensorkreises wird der von dem Meßwerk ausgegebene Meßwert mit dem Referenzwert verglichen und bei Abweichungen ein Warnsignal ausgegeben.

Die DE-A-31 21 645 schlägt ein Verfahren und eine gattungsbildende : Vorrichtung zur Überprüfung von in einem Fahrzeug angebrachten Gebern vor, bei dem mittels eines Mikroprozessors mehrere Geber überwachbar sind. Die Ausgangssignale der Geber werden einzeln einem Komparator zugeführt, der die Ausgangssignale mit vorgebbaren Grenzwerten vergleicht. Über einen Speicher werden bei einem Fehler Anzeigen aktiviert.

Die mit der Erfindung zu lösende Aufgabe wird darin gesehen, ein verbessertes Überwachungs- und/oder Steuersystem der eingangs genannten Art sowie verbesserte Verfahren anzugeben, welche das Wahrnehmen und Zuordnen zeitweise auftretender Fehler erlauben.

Die Aufgabe wird bei einem Überwachungs- und oder Steuersystem der eingangs genannten Art erfindungsgemäß durch die kennzeichnenden Merkmale des Patentanspruches 1 gelöst. Die erfindungsgemäßen Verfahrensschritte gehen aus den Patentansprüchen 2 bzw. 3 hervor.

Hierbei sind insbesondere mehrere Sensoren oder Sendeeinrichtungen durch jeweils gesonderte elektrische Leitungen oder Kabel mit einem zentralen elektrischen Datenverarbeitungs- oder Steuerkreis, welcher einen Mikroprozessor enthält, verbunden. Die Betätigung eines Schalters bringt den Mikroprozessor in einen Zustand, in dem ein spezieller Nachweisalgorithmus für zeitweise auftretende Fehler sich ständig wiederholend ausgeführt wird, während eine Bedienungsperson jede der Leitungen nacheinander bewegt, biegt, streckt oder walkt. Tritt hierbei bei einer Leitung ein zeitweise auftretender Fehler in Erscheinung, so verändert sich die Spannung oder der Strom in der Leitung, und der Fehlernachweisalgorithmus löst automatisch ein akustisches Signal aus.

Anhand der Zeichnung, die ein Ausführungsbeispiel der Erfindung zeigt, sollen die Erfindung sowie weitere Vorteile und vorteilhafte Weiterbildungen und Ausgestaltungen der Erfindung näher beschrieben und erläutert werden.

Es zeigt:

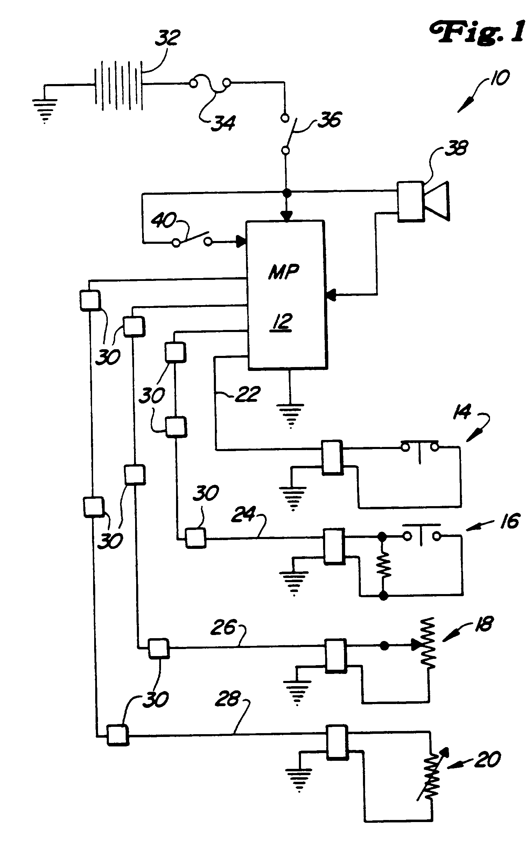

- Fig. 1: ein vereinfachtes, schematisches Diagramm eines Überwachungssystems, welches das Anzeigemerkmal für zeitweise auftretende Fehler gemäß der vorliegenden Erfindung enthält, und
- Fig. 2: das logische Flußdiagramm eines Algorithmus oder eines Computerprogramms, welches durch die zentrale Steuereinheit der Figur 1 ausgeführt wird.

Eine Überwachungs- und/oder Steuereinrichtung 10 enthält eine zentrale Steuer- oder Datenverarbeitungseinheit 12, welche mit mehreren Sensoren oder Sendeeinrichtungen, wie beispielsweise ein normalerweise geschlossener Schalter 14, ein normalerweise offener Schalter 16, ein potentiometerartiger Analogmeßfühler 18 und ein Analogmeßfühler 20 mit veränderlichem Widerstand, verbunden ist. Jede der Einrichtungen 14 bis 20 ist mit der zentralen Einheit 12 durch eine gesonderte, zugehörige Leitung 22, 24, 26 und 28 verbunden. Jede Leitung kann eine oder mehrere Steckverbindungen 30 enthalten.

Die zentrale Einheit 12 ist mit einer Spannungsquelle oder einer Batterie 32 über eine Sicherung 34 und einen Schalter 36, beispielsweise den Zündschloßschalter eines Fahrzeuges, verbunden. An einen Ausgangsanschluß der zentralen Einheit 12 und an den Schalter 36 ist ein akustisches Horn 38 angeschlossen. Zwischen dem Schalter 36 und einem Betriebsartsteuereingang der zentralen Einheit 12 ist ein von einer Bedienungsperson einstellbarer Betriebsartschalter 40 geschaltet.

Die zentrale Einheit 12 enthält einen gewöhnlichen Mikroprozessor, welcher programmierbar ist, um die Funktionsweisen der Einrichtungen 14 bis 20 beobachtbar zu machen und/oder verschiedene nicht dargestellte Funktionen in Abhängigkeit erfaßter Parameter zu steuern. Derartige Beobachtungs- und/oder Steuerfunktionen bilden jedoch nicht den Gegenstand der vorliegenden Erfindung.

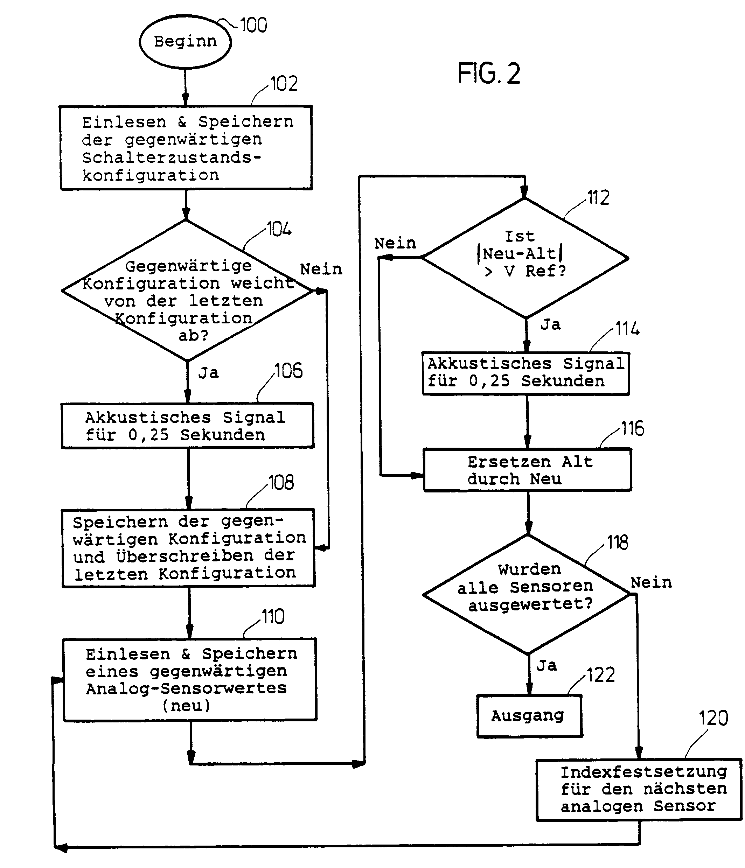

Entsprechend der vorliegenden Erfindung führt die zentrale Einheit 12 einen Diagnosealgorithmus aus, sofern der Schalter 40 von Hand geschlossen ist. Dieser Algorithmus wird anhand des logischen Flußdiagramms der Fig. 2 näher beschrieben.

Der Algorithmus beginnt mit Schritt 100, welcher periodisch, beispielsweise 32 mal in der Sekunde, ausgelöst wird, solange der Schalter 40 geschlossen bleibt. In Schritt 102 wird ein Satz von Statussignalen für die verschiedenen Schalter 14 und 16 eingelesen und in einem Speicher abgelegt, die durch elektrische Parameter repräsentiert sind, welche über die Leitungen 22 und 24 der zentralen Einheit 12 mitgeteilt werden. In Schritt 104 wird dann der gegenwärtige Satz der Statussignale mit einem anfänglichen oder vorher gespeicherten Satz von Statussignalen verglichen und dann, wenn die beiden Sätze nicht übereinstimmen mit Schritt 106 fortgefahren, welcher das Horn 38 aktiviert, so daß für eine bestimmte Zeitdauer ein akustisches Signal abgegeben wird. Stimmen hingegen beide Sätze überein, so schreitet der Algorithmus zu Schritt 108 weiter, in welchem der gegenwärtige Satz von Statussignalen in die Speicherplätze für die letzte Statussignalkonfiguration abgelegt werden.

In Schritt 110 wird dann das gegenwärtige Statussignal für einen ersten der analogen Sensoren 18, 20 eingelesen und gespeichert. In Schritt 112 wird der absolute Wert der Differenz zwischen dem gegenwärtigen Statussignalwert (NEU) und einem anfänglichen oder vorher gespeicherten Statussignalwert (ALT) gebildet. Ist der absolute Wert dieser Differenz größer als ein vorgebbarer Referenzbetrag VREF, so löst Schritt 114 ein akustisches Signal des Hornes 38 aus. Andernfalls schreitet der Algorithmus zu Schritt 116 weiter, in welchem das anfängliche oder vorher gespeicherte Statussignal durch das gegenwärtige Statussignal ersetzt wird. Sofern noch nicht die Statussignale aller analogen Sensoren ausgewertet sind, wird in Schritt 120 ein Indexwert geändert und der Algorithmus zu Schritt 110 zurückgeführt, so daß die Schritte 110 bis 116 für jeden analogen Sensor der Reihe nach wiederholt werden.

Nachdem die Statussignale für alle analogen Sensoren ausgewertet wurden, richtet Schritt 118 den Algorithmus auf Schritt 122, durch welchen der Zyklusablauf des Algorithmus beendet wird.

Wird ein zeitweise auftretender Fehler in einer der Leitungen 22 bis 28 oder einem der Verbindungsstecker 30 vermutet, so kann die Bedienungsperson den Schalter 40 schließen und von Hand nacheinander jede der Leitungen einer Bewegung, wie z. B. Zug oder Verbiegung, unterziehen. Tritt hierbei ein solcher Fehler auf, so ändert sich das entsprechende Statussignal zwischen zwei aufeinanderfolgenden Zyklusabläufen des Algorithmus und der Algorithmus reagiert mit einem akustischen Signal des Hornes 38. Auf diese Weise lassen sich zeitweise auftretende Fehler in Leitungen und Verbindungsstellen nachweisen und lokalisieren. Bei einer Sendeeinrichtung, wie beispielsweise einem gewöhnlich offenen Schalter 16, kann der Schalter 16 entfernt und durch eine Kurzschlußbrücke ersetzt werden, so daß Strom durch die Leitung 24 fließen kann und bei einem Zug oder einer Verbiegung der Leitung 24 eine Änderung der Spannung oder des Stromes herbeigeführt wird, was durch die zentrale Einheit 12 wahrgenommen wird.

Unter Zugrundelegung des oben beschriebenen Flußdiagramms und eines nachfolgend dargestellten Programms in Assemblersprache stellt es für den Fachmann keine Schwierigkeit dar, die Erfindung in ein überwachung- und Steuersystem, welches eine Datenverarbeitungseinrichtung, wie beispielsweise einen Mikroprozessor, enthält, einzufügen.

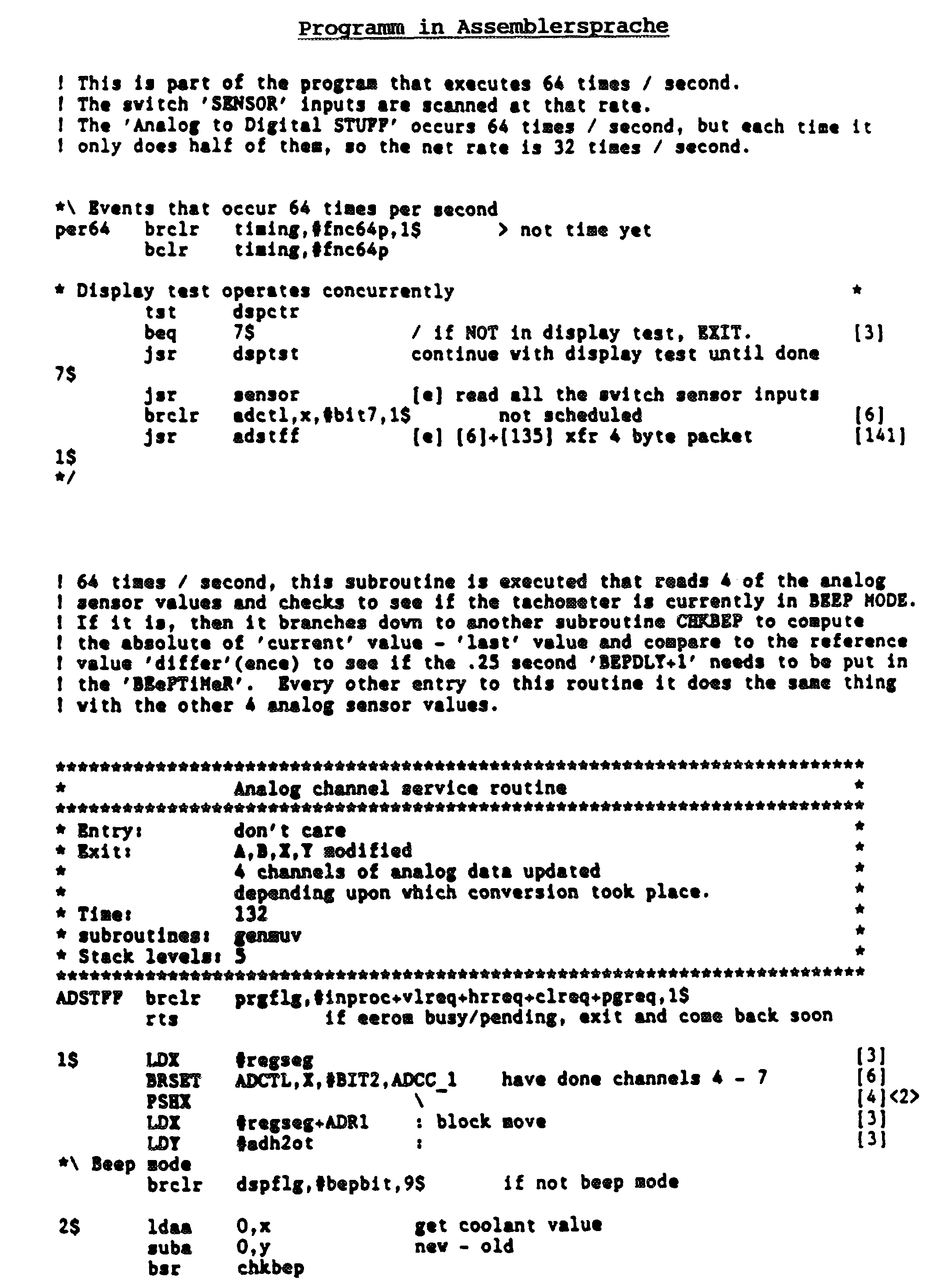

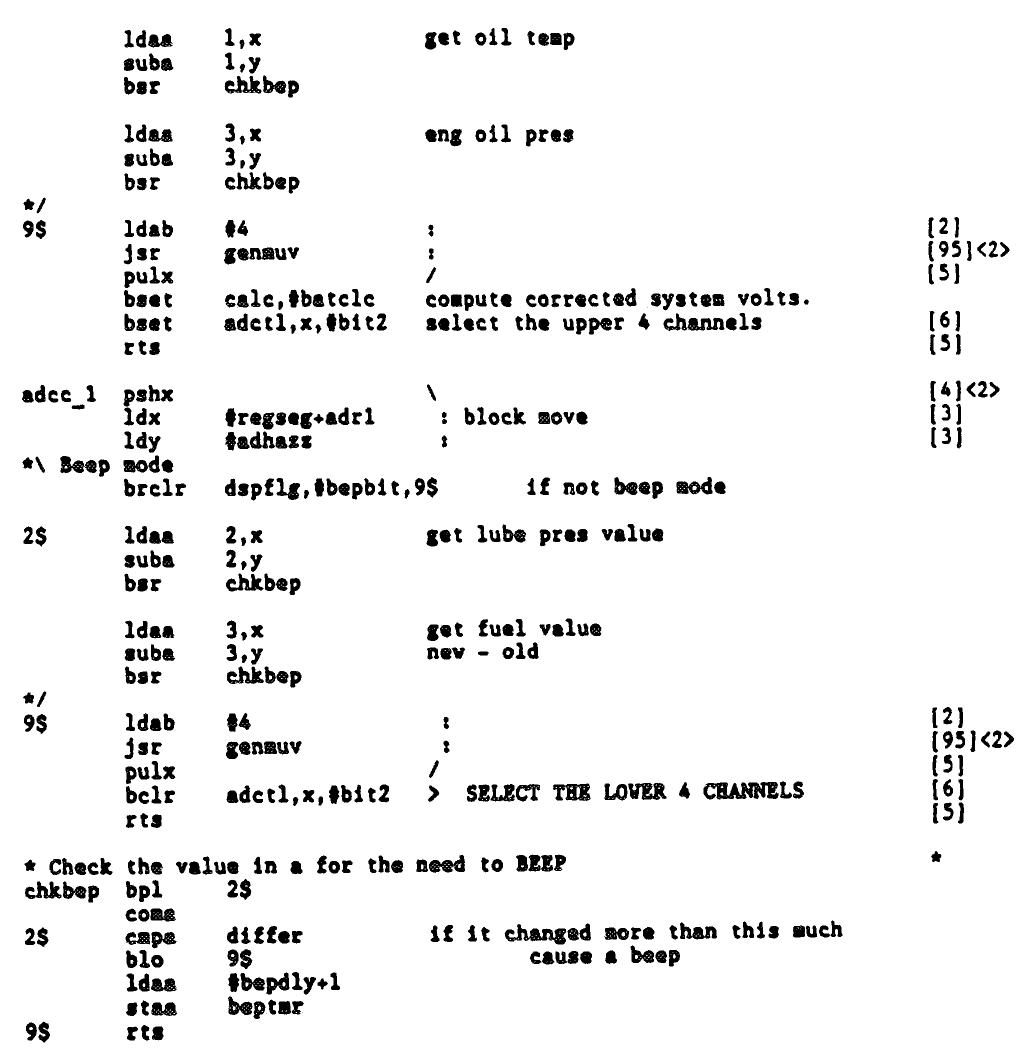

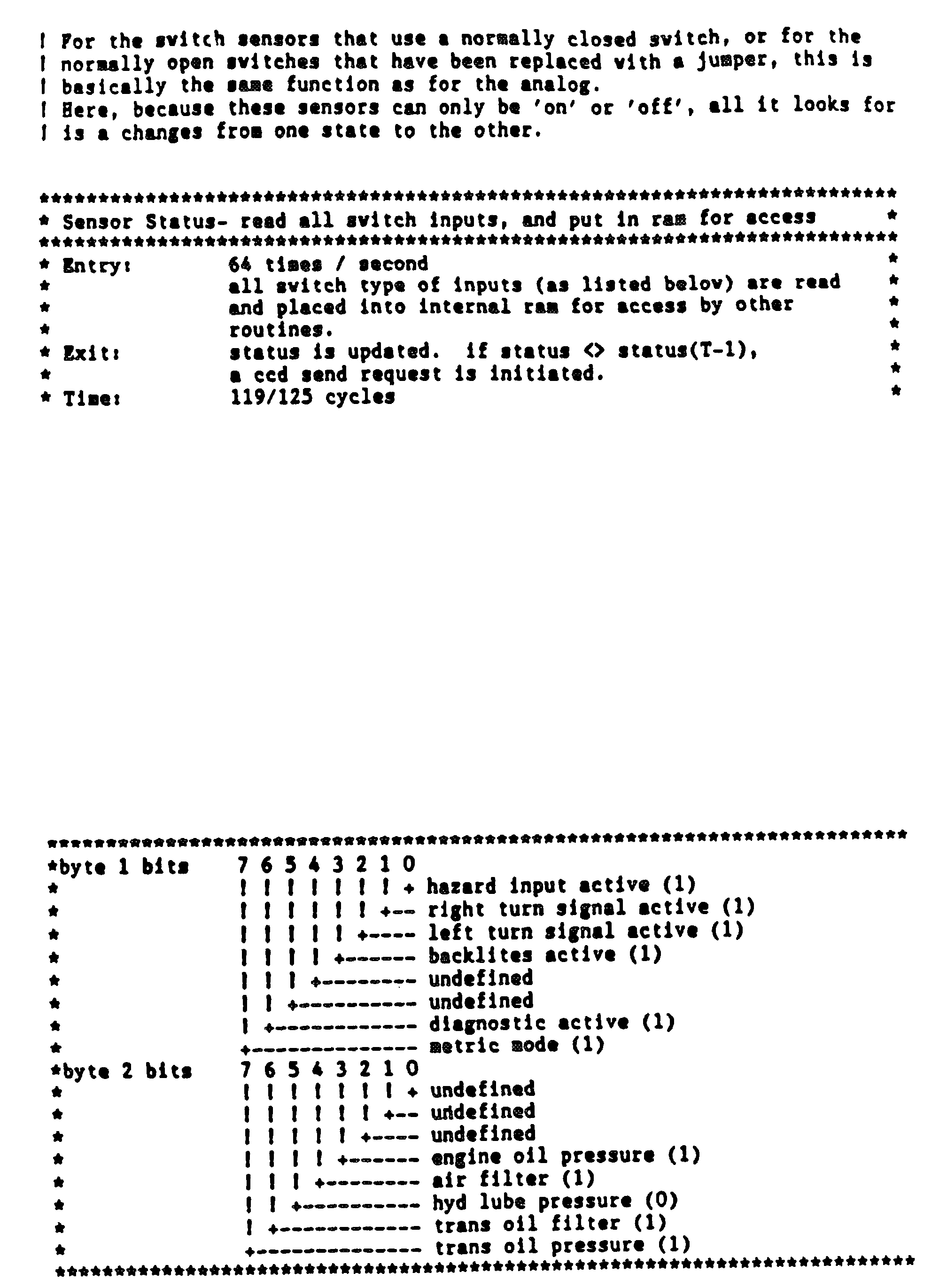

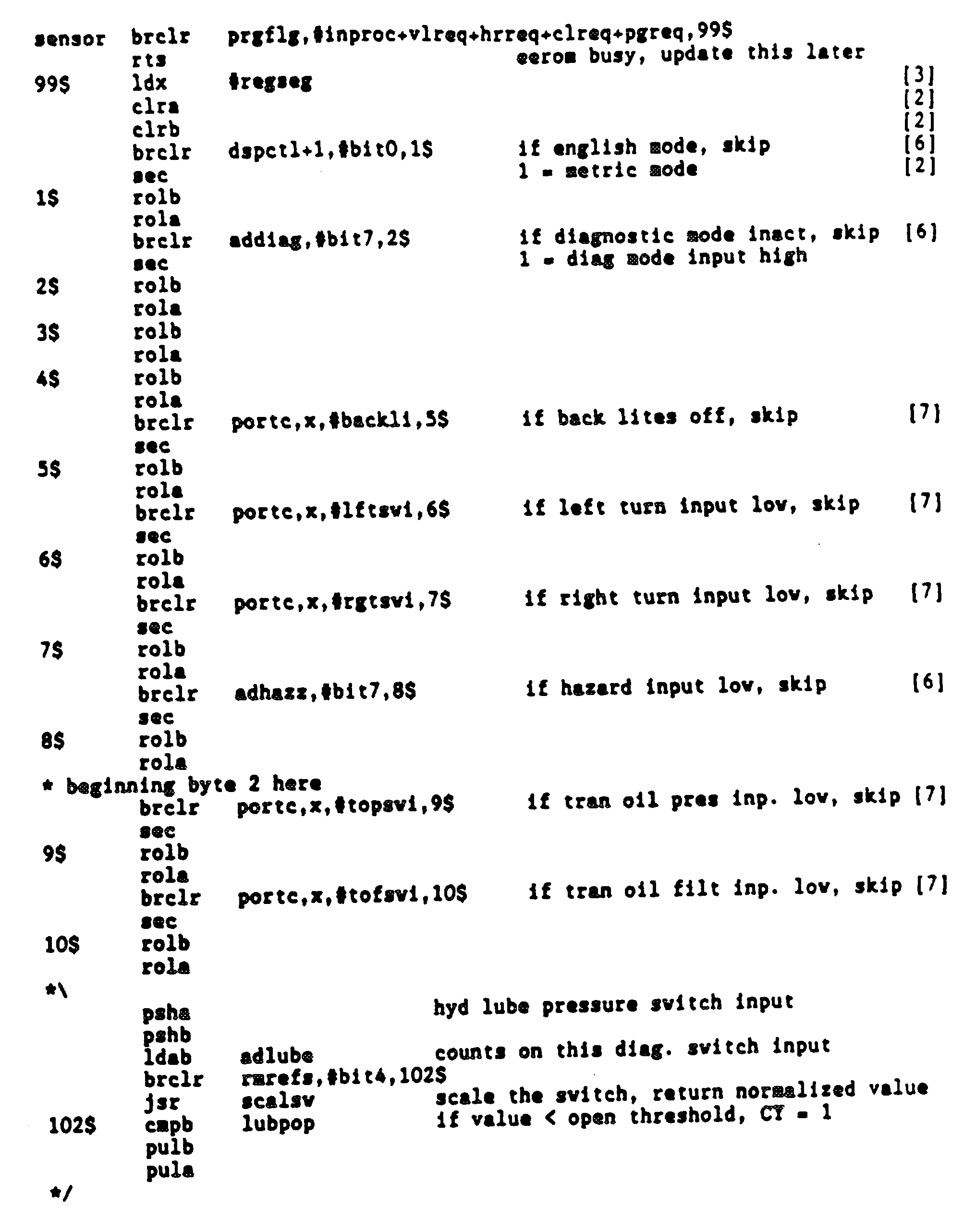

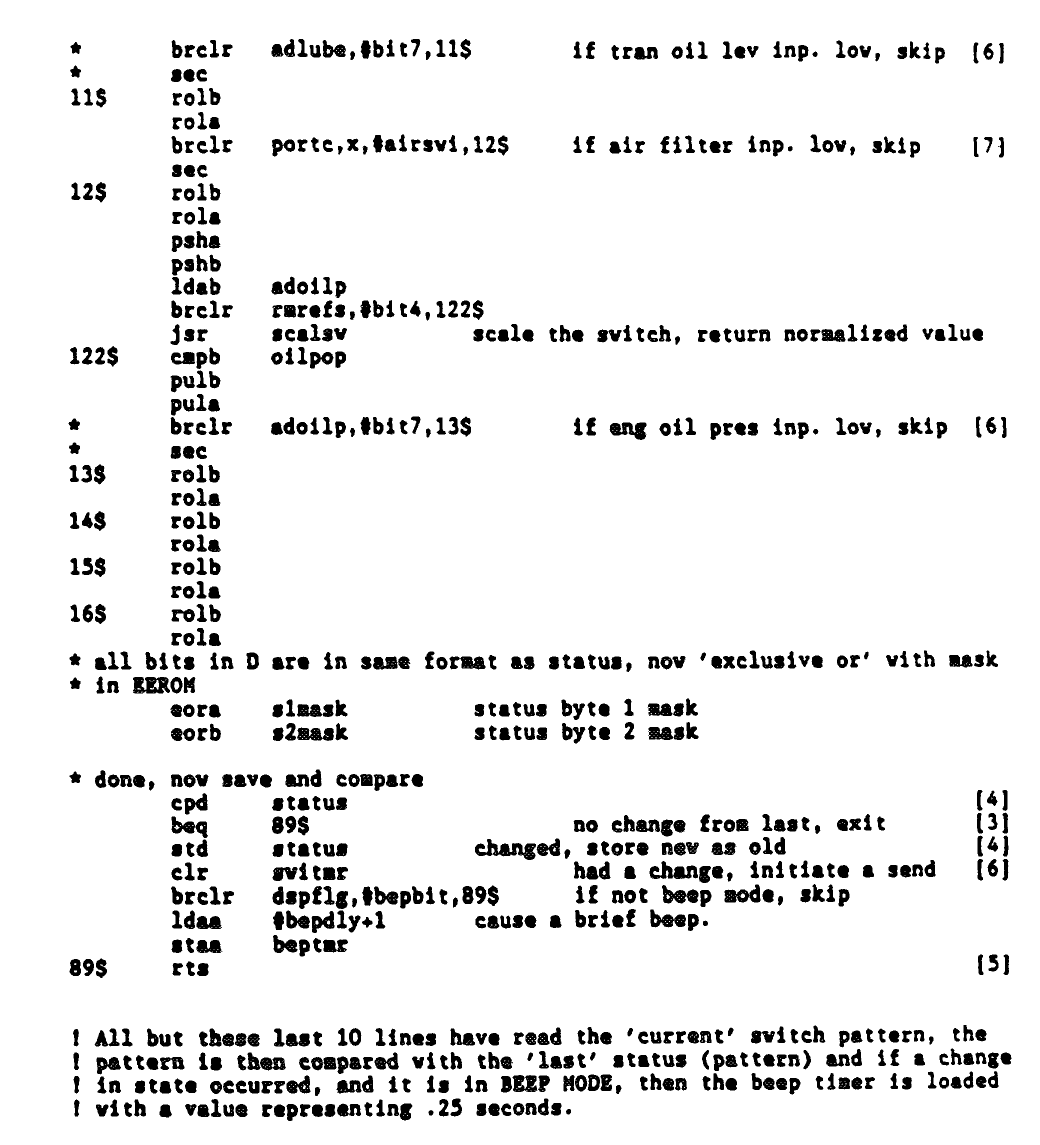

## Patentansprüche

1. Überwachungs- und/oder Steuersystem (10) mit mehreren Vorrichtungen (14 - 20), die über zugehörige Leitungen (22 - 28) elektrisch mit einer zentralen Einheit (12) in Verbindung stehen, mit Mitteln zur automatischen, periodischen und hinsichtlich der mehreren Vorrichtungen (14-20) sequenziellen Erzeugung von Differenzwerten, die jeweils die Differenz darstellen zwischen einem anfänglichen oder früher gespeicherten Wert einerseits und einem gegenwärtigen Wert andererseits, wobei diese Werte einem elektrischen Parameter einer der Vorrichtungen (14-20) zugeordnet sind, und mit Mitteln zur Erzeugung eines Signals, sofern einer der Differenzwerte einen vorgebbaren Referenzwert (VREF) übersteigt, dadurch gekennzeichnet, daß das Signal als akustisches Signal ausgebildet ist und daß in der zentralen Einheit (12) die den Vorrichtungen (14 - 20) zugeordneten anfänglichen oder früher gespeicherten Werte nach der Bildung der Differenzwerte automatisch und periodisch durch die gegenwärtigen Werte ersetzt werden.

2. Verfahren zur Erfassung zeitweise auftretender Fehler in elektrischen Leitungen (22 - 28) eines Überwachungs- und/oder Steuersystems (10), bei dem die elektrischen Leitungen (22 - 28) mehrere Vorrichtungen (14 - 20) elektrisch mit einer zentralen Einheit (12) verbinden, mit folgenden Verfahrensschritten, die periodisch aufeinanderfolgend ausgeführt werden, während die Leitungen (22 - 28) nacheinander manuell betätigt werden:
a) Erzeugung und Speichern eines ersten Satzes von Statussignalen, die den elektrischen Parametern der Leitungen (22 - 28) entsprechen,
b) anschließende Erzeugung eines zweiten Satzes von Statussignalen, die den elektrischen Parametern der Leitungen (22 - 28) entsprechen,
c) Vergleich des zweiten mit dem ersten Satz und Erzeugung eines akustischen Signals, wenn der zweite Satz sich von dem ersten Satz in ausreichender Weise unterscheidet, und
d) Ersetzung des ersten Satzes durch den zweiten Satz.

3. Verfahren zur Erfassung zeitweise auftretender Fehler in einem elektrischen Kreis, welcher mehrere Vorrichtungen (14 - 20) enthält, die jeweils über eine zugehörige Leitung (22 -28) mit einer zentralen Einheit (12) verbunden sind, mit folgenden Verfahrensschritten:
a) Speichern eines ersten Satzes von Statussignalen, die elektrischen Parametern der mehreren Vorrichtungen (14 - 20) zugeordnet sind und über die Leitungen (22 - 28) der zentralen Einheit (12) mitgeteilt werden,
b) Speichern eines zweiten Satzes von Statussignalen, die elektrischen Parametern der mehreren Vorrichtungen (14 - 20) zugeordnet sind und zu einem späteren Zeitpunkt als der erste Satz erfaßt werden,
c) Vergleichen des zweiten Satzes von Statussignalen mit dem ersten Satz von Statussignalen und Erzeugung eines akustischen Signals, wenn die Sätze unterschiedlich sind,
d) Umbenennen des zweiten Satzes von Statussignalen in den ersten Satz von Statussignalen und
e) periodisches Wiederholen der Verfahrensschritte a) bis d).

## Claims

1. A monitoring and/or control system (10) with a plurality of devices (14 - 20) which are electrically connected to a central unit (12) by corresponding conductors (22 - 28), with means for automatically, periodically generating difference values sequentially in relation to the plurality of devices (14 - 20), these difference values each representing a difference between an initial or previously stored value on the one hand and a present value on the other hand, wherein these values are associated with an electrical parameter of one of the devices (14 - 20), and with means for generating a signal insofar as one of the difference values exceeds a predetermined reference value (VREF), characterized in that the signal is in the form of an acoustic signal and in that the initial or previously stored values associated with the devices (14 - 20) are automatically and periodically replaced in the central unit (12) by the present values after formation of the difference values.

2. A method of detecting intermittently occurring faults in electrical conductors (22 - 28) of a monitoring and/or control system (10), in which the electrical conductors (22 - 28) connect a plurality of devices (14 - 20) electrically to a central unit (12), with the following method steps which are carried out periodically in sequence, while the conductors (22 - 28) are manually exercised one after the other:
a) generating and storing a first set of status signals, which correspond to the electrical parameters of the conductors (22 - 28),
b) then generating a second set of status signals which correspond to the electrical parameters of the conductors (22 - 28),
c) comparing the second set with the first set and generating an acoustic signal when the second set differs from the first set to a sufficient extent, and
d) replacing the first set by the second set.

3. A method of detecting intermittently occurring errors in an electrical circuit, which includes a plurality of devices (14 - 20) which are each connected to a central unit (12) by a corresponding conductor (22 - 28), with the following method steps:
a) storing a first set of status signals which correspond to electrical parameters of the plurality of devices (14 - 20) and are communicated to the central unit (112) over the conductors (22 - 28),
b) storing a second set of status signals with correspond to the electrical parameters of the plurality of devices (14 - 20) and are detected at a later instant than the first set,
c) comparing the second set of status signals with the first set of status signals and generating an acoustic signal when the sets are different,
d) renaming the second set of status signals as the first set of status signals and
e) periodically repeating the method steps a) to d).

## Revendications

1. Système de contrôle et/ou de commande (10) comportant plusieurs dispositifs (14-20), qui sont reliés électriquement, par l'intermédiaire de lignes associées (22-28), à une unité centrale (12), et comportant des moyens pour produire, d'une manière automatique, périodique et séquentielle du point de vue des différents dispositifs (14-20), des valeurs différentielles, qui représentent chacune la différence entre d'une part une valeur initiale ou mémorisée antérieurement et d'autre part une valeur actuelle, ces valeurs étant associées à un paramètre électrique de l'un des dispositifs (14-20), et comportant des moyens pour produire un signal, dans la mesure où l'une des valeurs différentielles dépasse une valeur de référence pouvant être prédéterminée (VREF), caractérisé en ce que le signal est fourni sous la forme d'un signal acoustique et que, dans l'unité centrale (12), les valeurs initiales ou mémorisées antérieurement, qui sont associées aux dispositifs (14-20), sont remplacées automatiquement et périodiquement, après la formation des valeurs différentielles, par les valeurs actuelles.

2. Procédé pour détecter des erreurs apparaissant par instants dans des lignes électriques (22-28) d'un système de contrôle et/ou de commande (10), dans lequel les lignes électriques (22-28) relient électriquement plusieurs dispositifs (14-20) à l'unité centrale (12), comportant les étapes opératoires suivantes, qui sont exécutées successivement de façon périodique, tandis que les lignes (22-28) sont actionnées manuellement de façon successive :
a) production et mémorisation d'un premier ensemble de signaux d'état, qui correspondent aux paramètres électriques des lignes (22-28),
b) production ultérieure d'un second ensemble de signaux d'état, qui correspondent aux paramètres électriques des lignes (22-28),
c) comparaison du second ensemble au premier ensemble et production d'un signal acoustique, lorsque le second ensemble diffère d'une manière suffisante du premier ensemble, et
d) remplacement du premier ensemble par le second ensemble.

3. Procédé pour détecter des erreurs apparaissant par instants dans un circuit électrique, qui contient plusieurs dispositifs (14-20), qui sont reliés respectivement par l'intermédiaire d'une ligne associée (22-28) à une unité centrale (12), comprenant les étapes opératoires suivantes :
a) mémorisation d'un premier ensemble de signaux d'état, qui sont associés à des paramètres électriques des différents dispositifs (14-20) et qui sont communiqués par l'intermédiaire des lignes (22-28) à l'unité centrale (12),
b) mémorisation d'un second ensemble de signaux d'état, qui sont associés à des paramètres électriques des différents dispositifs (14-20) et sont détectés à un instant ultérieur en tant que premier ensemble,
c) comparaison du second ensemble de signaux d'état au premier ensemble de signaux d'état et production d'un signal acoustique, lorsque les ensembles sont différents,
d) changement de dénomination du second ensemble de signaux d'état comme étant le premier ensemble de signaux d'état, et
e) répétition périodique des étapes opératoires a) à d).
